# EUROPEAN PATENT APPLICATION

(11) **EP 4 812 002 A2**
(43) Date of publication of application: **23.09.2026**
(21) Application number: 26164905.7
(22) Date of filing: 16.03.2026
(51) Int. Cl.: H10P 72/10, H10P 72/30

(54) **SUBSTRATE PROCESSING APPARATUS, METHOD OF PROCESSING SUBSTRATE, METHOD OF MANUFACTURING SEMICONDUCTOR DEVICE, AND PROGRAM**

(30) Priority: 21.03.2025 JP 2025046542
(71) Applicant: Kokusai Electric Corporation, Tokyo 100-0004 (JP)
(72) Inventor: YAMAMOTO, Takayuki, Toyama-shi, Toyama, 939-2393 (JP); TAHARA, Kaigo, Toyama-shi, Toyama, 939-2393 (JP); HORITA, Hideki, Toyama-shi, Toyama, 939-2393 (JP)
(74) Representative: Bardehle Pagenberg Partnerschaft mbB Patentanwälte Rechtsanwälte

(57) **Abstract**

A technique includes: a first mounter on which a first container capable of accommodating a substrate is mounted; a second mounter on which a second container capable of accommodating the substrate is mounted; a first supply system configured to supply a substance X to the second container; a transfer apparatus configured to be capable of transferring the substrate between the first container and the second container; a process container configured to process the substrate; and a controller configured to be capable of controlling the first supply system and the transfer apparatus so as to perform: (a) transferring the substrate from the first container to the second container; (b) supplying the substance X to the substrate accommodated in the second container; and (c) after (b), transferring the substrate on which the substance X is adsorbed from the second container to the process container.

## Description

### CROSS-REFERENCE TO RELATED APPLICATION

This application is based upon and claims the benefit of priority from Japanese Patent Application No. 2025-046542, filed on March 21, 2025, the entire contents of which are incorporated herein by reference.

### TECHNICAL FIELD

The present disclosure relates to a substrate processing apparatus, a method of processing a substrate, a method of manufacturing a semiconductor device, and a program.

### BACKGROUND

In related art, a process of etching a surface of a substrate may be performed as a process of manufacturing a semiconductor device.

### SUMMARY

Some embodiments of the present disclosure provide a technique capable of efficiently performing etching of a surface of a substrate.

According to some embodiments of the present disclosure, there is provided a technique that includes: a first mounter on which a first container configured to be capable of accommodating a substrate is mounted; a second mounter on which a second container configured to be capable of accommodating the substrate is mounted; a first supply system configured to supply a substance X to the second container; a transfer apparatus configured to be capable of transferring the substrate between the first container and the second container; a process container configured to process the substrate; and a controller configured to be capable of controlling the first supply system and the transfer apparatus so as to perform: (a) transferring the substrate from the first container to the second container; (b) supplying the substance X to the substrate accommodated in the second container; and (c) after (b), transferring the substrate on which the substance X is adsorbed from the second container to the process container.

### BRIEF DESCRIPTION OF DRAWINGS

The accompanying drawings, which are incorporated in and constitute a part of the specification, illustrate embodiments of the present disclosure.
FIG. 1 is a side cross-sectional view of a processing apparatus 1 suitably used in some embodiments of the present disclosure.
FIG. 2 is a schematic configuration diagram of a vertical process furnace of the processing apparatus 1 suitably used in some embodiments of the present disclosure, in which a portion of a process furnace is shown in a vertical cross-sectional view.
FIG. 3 is a schematic configuration diagram of the vertical process furnace of the processing apparatus 1 suitably used in some embodiments of the present disclosure, in which a portion of the process furnace is shown in a cross-sectional view taken along line A-A in FIG. 2.
FIG. 4 is a schematic configuration diagram of a controller of the processing apparatus 1 suitably used in some embodiments of the present disclosure, in which a control system of the controller is shown as a block diagram.

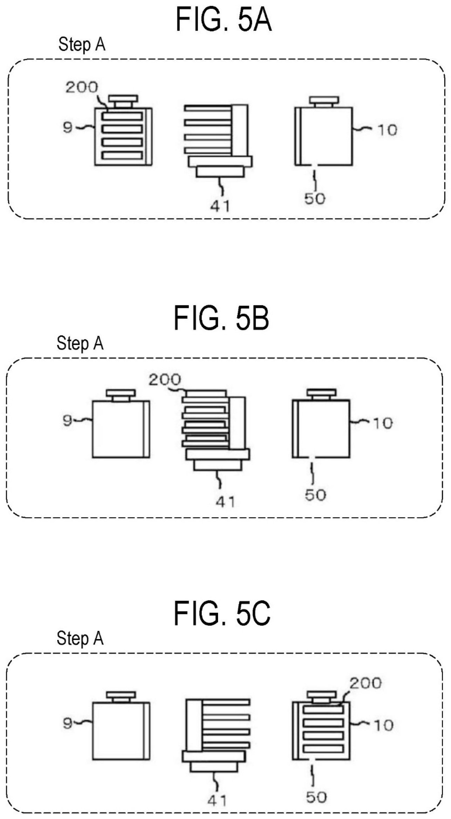

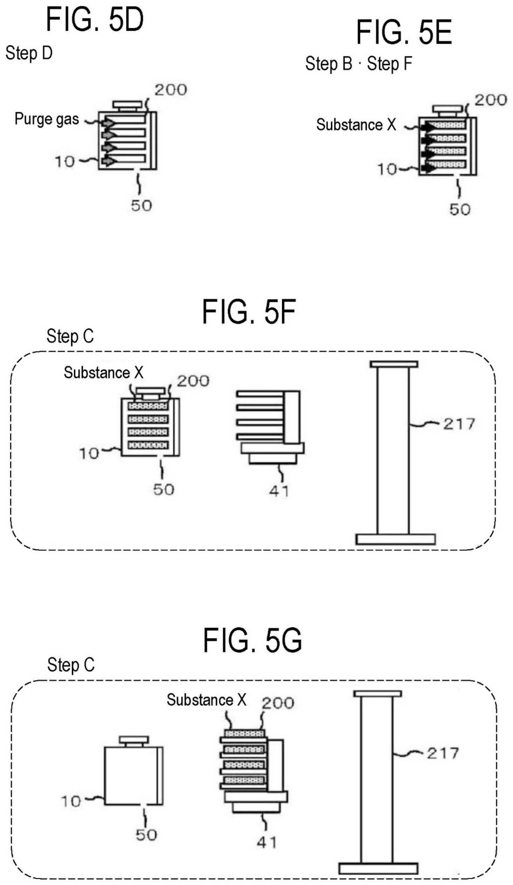

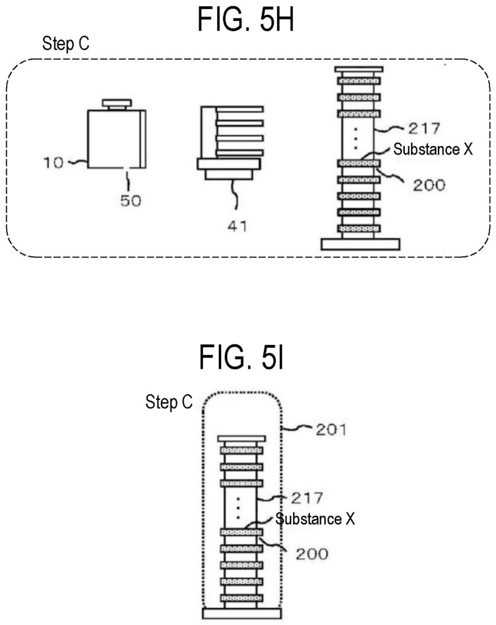

FIGS. 5A to 5C are schematic partial cross-sectional views of the processing apparatus 1 showing transfer of a wafer 200 from a pod 9 to a pod 10 by performing step A. FIG. 5D is a schematic partial cross-sectional view of the processing apparatus 1 showing supply of a purge gas to the wafer 200 accommodated in the pod 10 by performing step D. FIG. 5E is a schematic partial cross-sectional view of the processing apparatus 1 showing supply of a substance X to the wafer 200 accommodated in the pod 10 by performing step B. FIGS. 5F to 5I are schematic partial cross-sectional views of the processing apparatus 1 showing transfer of the wafer 200 on which the substance X is adsorbed from the pod 10 to the process chamber 201 by performing step C.

### DETAILED DESCRIPTION

Reference will now be made in detail to various embodiments, examples of which are illustrated in the accompanying drawings. In the following detailed description, numerous specific details are set forth in order to provide a thorough understanding of the present disclosure. However, it will be apparent to one of ordinary skill in the art that the present disclosure may be practiced without these specific details. In other instances, well-known methods, procedures, systems, and components are not described in detail so as not to unnecessarily obscure aspects of the various embodiments.

### <Embodiments of Present Disclosure>

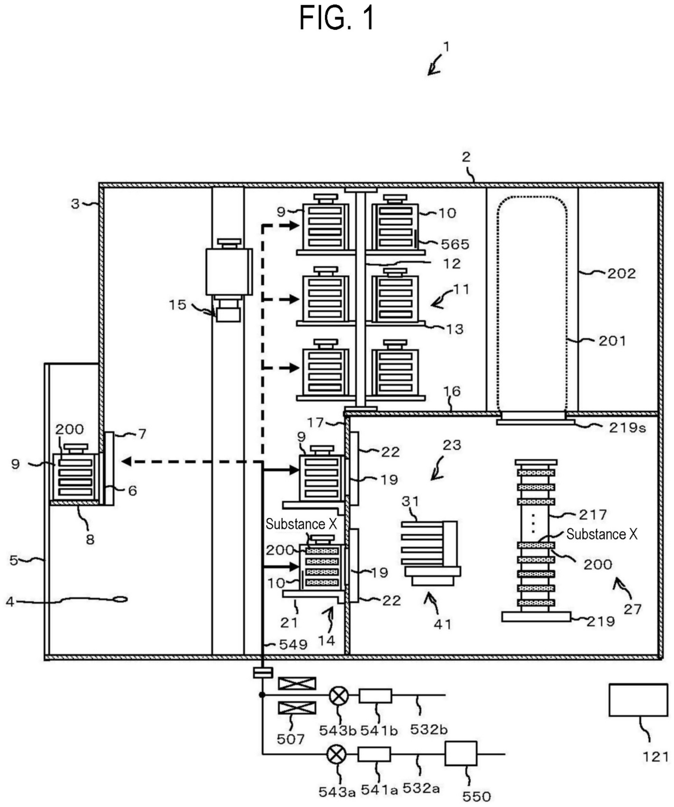

Hereinafter, some embodiments of the present disclosure will be described mainly with reference to FIGS. 1 to 4 and 5A to 5I. The drawings used in the following description are schematic, and dimensional relationships, ratios, and the like of respective elements illustrated in the drawings may not match actual ones. Further, dimensional relationships, ratios, and the like of respective elements among plural drawings may not match one another.

### (1) Configuration of Processing Apparatus

First, a configuration of a processing apparatus 1 will be described with reference to FIG. 1. The processing apparatus 1 suitably used in some embodiments of the present disclosure includes a housing 2. A front maintenance port 4 serving as an opening for which maintenance may be performed is installed at a lower side of a front wall 3 of the housing 2. The front maintenance port 4 is opened or closed by a front maintenance door 5.

A pod loading/unloading port 6 is installed at the front wall 3 of the housing 2 so as to be in fluid communication with an inside and an outside of the housing 2. The pod loading/unloading port 6 is opened or closed by a front shutter 7, which is a loading/unloading port opening/closing mechanism. A load port 8 serving as a first mounter, which is a substrate conveyance container delivery stand and a substrate conveyance container mounting stand, is installed on a front side of the pod loading/unloading port 6. The load port 8 is configured to align a location of a pod 9 serving as a first container mounted thereon.

The pod 9 is a sealed type substrate conveyance container. The pod 9 is, for example, a front opening unified pod (FOUP). The pod 9 is loaded onto or unloaded from the load port 8 by an in-process conveyance device (not shown). The front shutter 7 is configured to open or close a wafer entrance of the pod 9 by opening or closing a lid of the pod 9 mounted on the load port 8. The front shutter 7 may be included in the load port 8.

A pod shelf 11 (also simply referred to as the shelf 11), which is a substrate conveyance container storage shelf, is installed in an upper side of the housing 2 at a substantially central portion in a front-rear direction. The pod shelf 11 is configured to be capable of mounting pods 10 serving as a second container, which are a plurality of substrate conveyance containers. Furthermore, a humidity sensor 565 serving as a hygrometer (a humidity detector) may be installed inside the pod 10. The humidity sensor 565 is installed along an inner wall of the pod 10. Additionally, a purge port 50 configured to discharge a substance X, a purge gas, or the like, which will be described later, is formed in the pod 10. Although the pod 10 may be constituted as a FOUP configured to move within a semiconductor manufacturing facility similarly to the pod 9, the pod 10 may also be constituted as a container different from the FOUP configured to move within the semiconductor manufacturing facility. Furthermore, the pod shelf 11 may be constituted as a rotatable shelf.

When the pod shelf 11 is configured to be rotatable, the rotary pod shelf 11 includes a support pillar 12 vertically erected and intermittently rotated, and shelf plates 13, which is a plurality of stages of substrate conveyance container mounting shelves, radially supported at respective positions of upper, middle and lower stages on the support pillar 12. The shelf plate 13 is configured to store the pods 10 in a state in which at least one pod 10 is mounted.

A pod opener 14 serving as a second mounter, which is a substrate conveyance container lid opening/closing mechanism and a substrate conveyance container mounting stand, is installed below the pod shelf 11. The pod opener 14 is configured to be capable of mounting the pod 10. The pod opener 14 is also configured to be capable of opening or closing a lid of the pod 10. The pod opener 14 is constituted as a port capable of opening or closing the pod 10.

A pod conveyance mechanism 15, which is a container conveyance mechanism, is installed between the load port 8, the port shelf 11, and the pod opener 14. The pod conveyance mechanism 15 is configured to be capable of moving up or down and moving forward or backward in a horizontal direction while holding the pod 9 and the pod 10. The pod conveyance mechanism 15 is configured to convey the pod 9 and the pod 10 between the load port 8, the pod shelf 11, and the pod opener 14

A sub-housing 16 is installed in a lower side of the housing 2 at the substantially center portion of the housing 2 in the front-rear direction to extend toward a rear end of the housing 2. A pair of loading/unloading ports 19, which are substrate loading/unloading ports configured to load or unloading a wafer 200 into or from the sub-housing 16, is formed at a front wall 17 of the sub-housing 16 in two stages (upper and lower stages) in a vertical direction. The pod opener 14 is installed at each of the loading/unloading ports of the upper and lower stages.

As described below, in the embodiments, a predetermined preparation process (a process of adsorbing a substance X and then supplying a heated purge gas) is performed on the wafer 200 accommodated in the pod 10 as a substrate to be processed. Thereafter, the wafer 200 on which the preparation process was performed is conveyed into the process chamber 201 via the transfer chamber 23 and the standby part 27 and a predetermined process such as an etching process or a film formation process is performed on the wafer 200. To perform the preparation process, various devices described below are installed in the housing 2 (excluding the sub-housing 16 and a process furnace 202) according to the embodiments.

First, the housing 2 (excluding the sub-housing 16 and the process furnace 202) is provided with a gas supply path 549 serving as an introduction port for the substance X or a purge gas. A gas supply pipe 532a is connected to the gas supply path 549. The gas supply pipe 532a is provided with a vaporizer 550, a mass flow controller (MFC) 541a serving as a flow rate controller (flow rate control part), and a valve 543a serving as an opening/closing valve in this order from an upstream side of a gas flow. A gas supply pipe 532b is connected to the gas supply pipe 532a at a downstream of the valve 543a. The gas supply pipe 532b is provided with a MFC 541b and a valve 543b in this order from the upstream side of the gas flow. The gas supply pipes 532a and 532b are made of, for example, a metallic material such as stainless steel (SUS). A pipe heater 507 (simply referred to as the heater 507) serving as a heating part is disposed on an outer circumference of the gas supply pipe 532b. The substance X may be vaporized by bubbling, boiling, or ultrasonic vibration thereof by using the vaporizer 550. A position of the gas supply path 549 shown is schematic. The gas supply path 549 may be configured to be connectable to the pod shelf 11 or a mounter of the pod opener 14. The gas supply path 549 may also be configured to be connected to a supply port that is installed in the mounter of the pod opener 14 or a mounter of the pod 10 of the pod shelf 11 to supply gas to the pod 10.

The substance X is supplied from the gas supply pipe 532a into the pod 10 via the vaporizer 550, the MFC 541a, the valve 543a, and the gas supply path 549.

An inert gas is supplied from the gas supply pipe 532b into the pod 10 via the MFC 541b, the valve 543b, and the gas supply path 549. The inert gas serves as a purge gas, a carrier gas, or a dilution gas.

A first supply system mainly includes the gas supply pipe 532a, the MFC 541a, and the valve 543a. The first supply system is also referred to as a substance (X) supply system. A second supply system mainly includes the gas supply pipe 532b, the MFC 541b, and the valve 543b. The second supply system is also referred to as a first purge gas supply system or a first inert gas supply system.

Any one or the entirety of the various supply systems described above may be constituted as an integrated supply system 248 in which the valves 543a and 543b, the MFCs 541a and 541b, or the like are integrated. The integrated supply system 248 is connected to each of the gas supply pipes 532a and 532b and is configured such that the supply operations of various substances (various gases) within the gas supply pipes 532a and 532b, i.e., the opening/closing operations of the valves 543a and 543b or the flow rate control operations by the MFCs 541a and 541b are controlled by a controller 121 described later. The integrated supply system 248 is constituted as an integral or divided integrated unit and may be attached to or detached from the gas supply pipes 532a and 532b on an integrated unit basis. Thus, maintenance, replacement, or expansion of the integrated supply system 248 may be performed on the integrated unit basis.

The pod opener 14 includes a mounting stand 21 on which the pod 9 and the pod 10 are mounted and an opening/closing mechanism 22 configured to open or close lids of the pod 9 and the pod 10. The pod opener 14 is configured to open or close wafer entrances of the pod 9 and the pod 10 by opening or closing the lids of the pod 9 and the pod 10 mounted on the mounting stand 21 by the opening/closing mechanism 22.

The sub-housing 16 constitutes a transfer chamber 23 hermetically sealed from a space (pod conveyance space) in which the pod conveyance mechanism 15 or the pod shelf 11 is disposed. A transfer apparatus 41, which is a substrate transfer mechanism, is installed in a front region of the transfer chamber 23. The transfer apparatus 41 includes a demanded number of wafer mounting plates 31 (e.g., four wafer mounting plates in the figure) on which the wafers 200 are mounted. Each of the wafer mounting plates 31 is configured to be linearly movable in the horizontal direction, rotatable in the horizontal direction, or movable up or down. The transfer apparatus 41 is configured to charge or discharge the wafer 200 into or from a boat 217, which is a substrate holder. The transfer apparatus 41 is configured to be capable of conveying the wafer 200 between the pod 9 mounted on the mounting stand 21 and the pod 10 mounted on the mounting stand 21.

A standby part 27 configured to accommodate and keep the boat 217 in a standby state is formed in a rear region of the transfer chamber 23 and a vertical process furnace 202 is installed above the standby part 27. The process furnace 202 forms a process chamber 201 therein. A lower end of the process chamber 201 is constituted as a furnace opening. The furnace opening is opened or closed by a furnace opening shutter 219s, which is a furnace opening opening/closing mechanism. The process chamber 201 is an example of a process container configured to process the wafer 200.

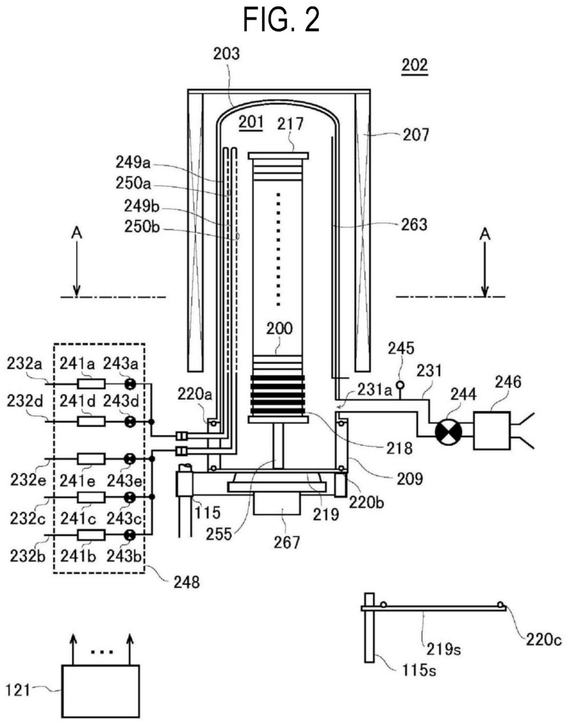

A boat elevator 115 *(see* FIG. 2), which is a substrate holder elevating mechanism configured to elevate the boat 217 is installed between a right end of the housing 2 and a right end of the standby part 27 of the sub-housing 16. A seal cap 219 serving as a lid is horizontally attached to an arm connected to an elevation base of the boat elevator 115. The seal cap 219 vertically supports the boat 217 and is configured to be capable of hermetically sealing the furnace opening in a state in which the boat 217 is charged in the process chamber 201.

The boat 217 is configured to hold a plurality of wafers 200 (e.g., 50 to 125 wafers) in such a state that wafers 200 are arranged in a horizontal posture and in multiple stages with centers of the wafers 200 aligned with one another.

A cleaner (not shown) is disposed at a position opposite the boat elevator 115. The cleaner includes a supply fan and a dustproof filter so as to supply clean air which is a purified atmosphere or an inert gas. A notch alignment apparatus (not shown) serving as a substrate aligner configured to align positions of the wafers 200 in the circumferential direction is installed between the transfer apparatus 41 and the cleaner.

The clean air discharged by the cleaner is circulated through the notch alignment apparatus, the transfer apparatus 41, and the boat 217 and is then drawn into a duct (not shown) and exhausted to the outside of the housing 2 or is discharged into the transfer chamber 23 by the cleaner.

Next, an operation of the processing apparatus 1 will be described.

When the pod 9 is supplied to the load port 8, the pod loading/unloading port 6 is opened by the front shutter 7. The pod 9 mounted on the load port 8 is loaded into the housing 2 via the pod loading/unloading port 6 by the pod conveyance mechanism 15 and is mounted either on the shelf plate 13 of the pod shelf 11 or on the mounting stand 21 of the pod opener 14. After being temporarily stored on the pod shelf 11, the pod 9 is conveyed from the shelf plate 13 to any one of the pod openers 14 by the pod conveyance mechanism 15 and is transferred to the mounting stand 21. The wafer 200 accommodated in the pod 9 mounted on the mounting stand 21 is accommodated in the pod 10 by the transfer apparatus 41. In the present disclosure, in this case, a purge gas is supplied into the pod 10 from the second supply system, and details thereof will be described later.

In this case, the loading/unloading port 19 is closed by the opening/closing mechanism 22. The clean air is circulated through the transfer chamber 23 and fills the transfer chamber 23. For example, the transfer chamber 23 is filled with a nitrogen (N)-containing gas as the clean air, and oxygen concentration therein is set to be lower than that in the interior (atmospheric environment) of the housing 2, for example, 20 ppm or less.

Subsequently, in the present disclosure, the substance X is supplied into the pod 10 from the first supply system, and details thereof will be described later.

The pod 10 mounted on the mounting stand 21 includes an opening side end surface pressed against an opening edge of the loading/unloading port 19 in the front wall 17 of the sub-housing 16. At the same time, the lid of the pod 10 is separated by the opening/closing mechanism 22, thereby opening the wafer entrance.

Thereafter, the wafer 200 is taken out of the pod 10 by the transfer apparatus 41 and charged into the boat 217. The transfer apparatus 41 that charged the wafer 200 into the boat 217 returns to the pod 10 to charge the next wafer 200 into the boat 217.

During a charging process of the wafer 200 into the boat 217 by the transfer apparatus 41 in one (upper or lower) pod opener 14, another pod 10 is conveyed and transferred by the pod conveyance mechanism 15 from the pod shelf 11 to the other (lower or upper) pod opener 14 and is opened by the other pod opener 14 at the same time.

When a predetermined number of wafers 200 is charged in the boat 217, the furnace opening of the process furnace 202 which was closed by the furnace opening shutter 219s is opened by the furnace opening shutter 219s. Subsequently, the boat 217 holding the wafers 200 is raised by the boat elevator 115 and loaded into the process chamber 201.

After being loaded, the wafers 200 are subjected to an arbitrary process within the process chamber 201. After processing, except for a wafer alignment process performed by the notch alignment apparatus, the boat 217 storing the processed wafers 200 is unloaded from the process chamber 201 in substantially reverse order of the above-described procedure, and the pod storing the processed wafers 200 is then unloaded out of the housing 2.

### (2) Configuration of Process furnace

Next, a configuration of the process furnace 202 will be described with reference to FIG. 2.

As shown in FIG. 2, the process furnace 202 of the processing apparatus 1 includes a heater 207 serving as a temperature regulator (a heating part). The heater 207 is formed in a cylindrical shape and is supported by a holding plate to be vertically installed. The heater 207 also functions as an activator configured to thermally activate a gas.

A reaction tube 203 is disposed inside the heater 207 to be concentric with the heater 207. The reaction tube 203 is made of, for example, a heat resistant material such as quartz (SiO₂) or silicon carbide (SiC) and formed in a cylindrical shape with its upper end closed and its lower end opened. A manifold 209 is disposed to be concentric with the reaction tube 203 below the reaction tube 203. The manifold 209 is made of, for example, a metal material such as SUS and formed in a cylindrical shape with its upper and lower ends opened. The upper end of the manifold 209 engages with the lower end of the reaction tube 203 so as to support the reaction tube 203. An O-ring 220a serving as a seal is installed between the manifold 209 and the reaction tube 203. Similar to the heater 207, the reaction tube 203 is vertically installed. A process container (reaction container) mainly includes the reaction tube 203 and the manifold 209. A process chamber 201 is formed in a hollow cylindrical area of the process container. The process chamber 201 is configured to be capable of accommodating the wafer 200 as the substrate. Inside this process chamber 201, a process is performed on the wafer 200.

Nozzles 249a and 249b serving as first and second suppliers are installed within the process chamber 201 so as to penetrate a sidewall of the manifold 209. The nozzles 249a and 249b will be also referred to as first and second nozzles, respectively. The nozzles 249a and 249b are each made of, for example, a heat resistant material such as quartz or SiC. Gas supply pipes 232a and 232b are connected to the nozzles 249a and 249b, respectively. The nozzles 249a and 249b are different from each other, and the nozzles 249a and 249c are each installed adjacent to each other.

Mass flow controllers (MFCs) 241a and 241b and valves 243a and 243b are respectively installed at the gas supply pipes 232a and 232b sequentially from an upstream side of a gas flow. A gas supply pipe 232d is connected to the gas supply pipe 232a at the downstream side of the valve 243a. Gas supply pipes 232c and 232e are each connected to the gas supply pipe 232b at the downstream side of the valve 243b. MFCs 241d and 241e and valves 243d and 243e are respectively installed at the gas supply pipes 232d and 232e sequentially from the upstream side of the gas flow. The gas supply pipes 232a to 232e are made of, for example, a metallic material such as SUS.

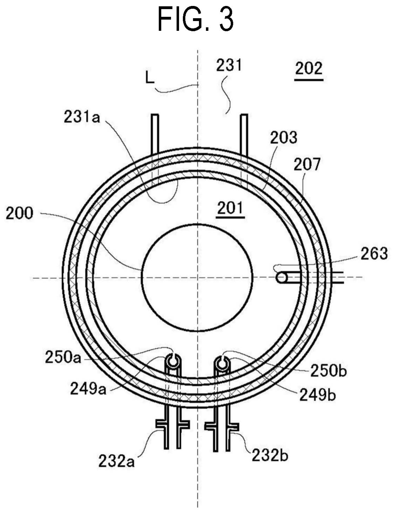

As shown in FIG. 3, each of the nozzles 249a to 249c is installed in an annular space (in plane view) between an inner wall of the reaction tube 203 and the wafers 200 so as to extend upward from a lower side to an upper side of the inner wall of the reaction tube 203, that is, along an arrangement direction of the wafers 200. Specifically, each of the nozzles 249a to 249b is installed in a region horizontally surrounding a wafer arrangement region in which the wafers 200 are arranged at a lateral side of the wafer arrangement region, along the wafer arrangement region. In plane view, the nozzles 249a and 249c are arranged with a straight line L passing through the center of the wafer 200 and a center of an exhaust port 231a in the process chamber 201 interposed therebetween, along the inner wall of the reaction tube 203 (an outer periphery of the wafer 200). Gas supply holes 250a and 250b configured to supply gas are respectively formed on side surfaces of the nozzles 249a and 249b. The gas supply holes 250a and 250b are each opened to oppose (face) the exhaust port 231a in plane view, which enables the gas to be supplied toward the wafer 200. A plurality of gas supply holes 250a and 250b is formed over a range from the lower side to the upper side of the reaction tube 203.

A fluorine (F)-containing material serving as an etchant is supplied from the gas supply pipe 232a into the process chamber 201 via the MFC 241a, the valve 243a, and the nozzle 249a.

A precursor serving as a processing agent is supplied from the gas supply pipe 232b into the process chamber 201 via the MFC 241b, the valve 243b, and the nozzle 249b. The precursor is used as a film-forming agent.

A reducing agent serving as the processing agent is supplied from the gas supply pipe 232c into the process chamber 201 via the MFC 241c, the valve 243c, and the nozzle 249c.

An inert gas is supplied from the gas supply pipes 232d and 232e into the process chamber 201 via the MFCs 241d and 241e, the valves 243d and 243e, the gas supply pipes 232a and 232b, and the nozzles 249a and 249b. The inert gas acts as a purge gas, a carrier gas, or a dilution gas.

A fluorine-containing material supply system serving as an etchant supply system mainly includes the gas supply pipe 232a, the MFC 241a, and the valve 243a. A precursor supply system serving as a processing agent supply system mainly includes the gas supply pipe 232b, the MFC 241b, and the valve 243b. A reducing agent supply system serving as the processing agent supply system mainly includes the gas supply pipe 232c, the MFC 241c, and the valve 243c. A second inert gas supply system mainly includes the gas supply pipes 232d and 232e, the MFCs 241d and 241e, and the valves 243d and 243e. The precursor supply system is also called a film-forming agent supply system. The second inert gas supply system is also called a second purge gas supply system or a second dilution gas supply system. Furthermore, the valves 243a to 243e or the MFCs 241a to 241e may be part of the integrated supply system 248, similar to the valves 543a and 543b or the MFCs 541a and 541b.

The exhaust port 231a configured to exhaust an internal atmosphere of the process chamber 201 is installed below a sidewall of the reaction tube 203. As shown in FIG. 2, the exhaust port 231a is installed at a position opposing (facing) the nozzles 249a and 249b (the gas supply holes 250a and 250b) in plane view, with the wafer 200 interposed therebetween. The exhaust port 231a may be installed from the lower side to the upper side of the sidewall of the reaction tube 203, that is, along the wafer arrangement region. An exhaust pipe 231 is connected to the exhaust port 231a. A vacuum pump 246 serving as a vacuum exhauster is connected to the exhaust pipe 231 via a pressure sensor 245 serving as a pressure detector (pressure detection part) configured to detect the internal pressure of the process chamber 201 and an automatic pressure controller (APC) valve 244 serving as a pressure regulator (pressure regulation part). The APC valve 244 is configured to be capable of performing or stopping vacuum exhaust in the process chamber 201 by opening or closing the valve while the vacuum pump 246 is operated, and is also configured to be capable of regulating the internal pressure of the process chamber 201 by adjusting a degree of valve opening based on pressure information detected by the pressure sensor 245 while the vacuum pump 246 is operated. An exhaust system mainly includes the exhaust pipe 231, the APC valve 244, and the pressure sensor 245. The vacuum pump 246 may be included in the exhaust system.

A seal cap 219 serving as a furnace opening lid configured to be capable of hermetically sealing a lower end opening of the manifold 209, i.e., a loading/unloading port of the wafer 200, is installed below the manifold 209. The seal cap 219 is made of, for example, a metal material such as SUS and is formed in a disc shape. An O-ring 220b serving as a seal making contact with the lower end of the manifold 209 is installed on an upper surface of the seal cap 219. A rotator 267 configured to rotate the boat 217 to be described later is installed below the seal cap 219. A rotary shaft 255 of the rotator 267 penetrates the seal cap 219 and is connected to the boat 217. The rotator 267 is configured to rotate the wafer 200 by rotating the boat 217. The seal cap 219 is configured to be vertically moved up or down by a boat elevator 115 serving as an elevator installed outside the reaction tube 203. The boat elevator 115 is constituted as a conveyance apparatus (conveyance mechanism) configured to convey the wafer 200 into or from the process chamber 201, i.e., between the interior of the process chamber 201 and the interior of the standby part 27, by moving the seal cap 219 up or down.

The furnace opening shutter 219s, which serves as a furnace opening lid configured to be capable of hermetically sealing the lower end opening of the manifold 209, i.e., the loading/unloading port of the wafer 200 in a state in which the boat 217 is unloaded from the interior of the process chamber 201 by moving the seal cap 219 down, is installed below the manifold 209. The furnace opening shutter 219s is made of, for example, a metal material such as SUS and is formed in a disc shape. An O-ring 220c, which serves as a seal making contact with the lower end of the manifold 209, is installed at an upper surface of the furnace opening shutter 219s. An opening/closing operation (elevation operation, rotation operation, or the like) of the furnace opening shutter 219s is controlled by a shutter opening/closing mechanism 115s.

The boat 217 serving as a substrate support is configured to support a plurality of wafers 200, for example, 25 to 200 wafers, in such a state that the wafers 200 are arranged in a horizontal posture and in multiple stages along a vertical direction with the centers of the wafers 200 aligned with one another. That is, the boat 217 is configured to arrange the wafers 200 to be spaced apart from each other. The boat 217 is made of, for example, a heat resistant material such as quartz or SiC. Heat insulating plates 218 made of, for example, a heat resistant material such as quartz or SiC are installed below the boat 217 in multiple stages.

A temperature sensor 263 serving as a temperature detector is installed in the reaction tube 203. Based on temperature information detected by the temperature sensor 263, a state of supplying electric power to the heater 207 is regulated such that a desired temperature distribution is achieved inside the process chamber 201. The temperature sensor 263 is installed along the inner wall of the reaction tube 203.

Next, a controller configured to control the above-described processing apparatus 1 will be described.

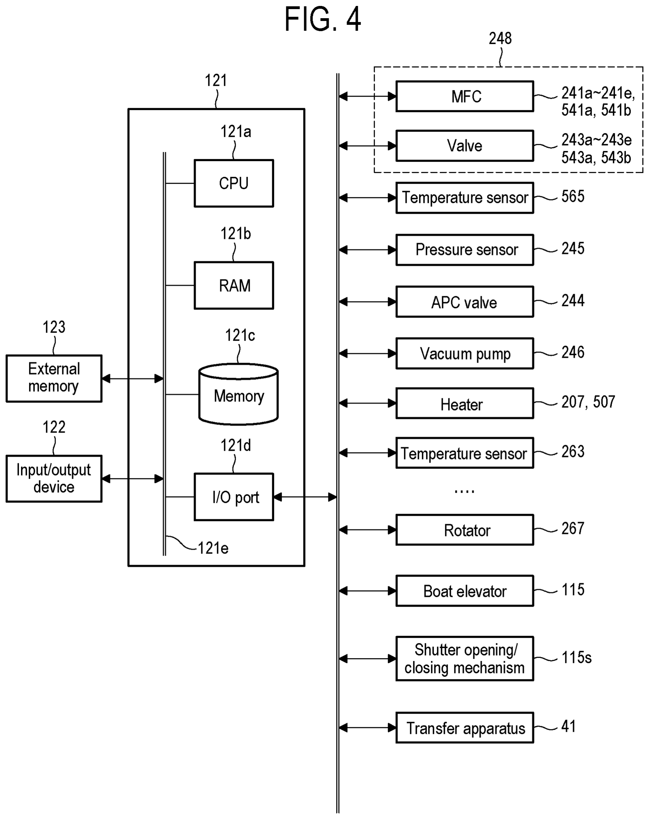

As shown in FIG. 4, a controller 121, which is a control part (control means or unit), is constituted as a computer including a central processing unit (CPU) 121a, a random access memory (RAM) 121b, a memory 121c, and an I/O port 121d. The RAM 121b, the memory 121c, and the I/O port 121d are configured to be capable of exchanging data with the CPU 121a via an internal bus 121e. An input/output device 122 including, e.g., a touch panel or the like, is connected to the controller 121. Further, an external memory 123 may be connected to the controller 121. Further, the processing apparatus 1 may be configured to include one controller, or may be configured to include a plurality of controllers. That is, control to perform a processing sequence to be described later may be performed by using one controller, or may be performed by using a plurality of controllers. Further, the plurality of controller may be constituted as a control system in which the plurality of controllers are connected to each other via a wired or wireless communication network, and the entire control system may perform control to perform the processing sequence to be described later. When the term "controller" is used in the present disclosure, it may include one controller, a plurality of controllers, or a control system constituted by a plurality of controllers.

The memory 121c includes, for example, a flash memory, a hard disk drive (HDD), a solid state drive (SSD), or the like. A control program that controls the operation of the processing apparatus 1, a process recipe in which sequences or conditions of substrate processing described below are written, and the like are readably recorded and stored in the memory 121c. The process recipe functions as a program combined to cause, by the controller 121, the processing apparatus 1 to execute each sequence in the substrate processing, which will be described later, to obtain an expected result. Hereinafter, the process recipe and the control program may be generally and simply referred to as a "program (program product)." Furthermore, the process recipe may be simply referred to as a "recipe." When the term "program" is used herein, it may indicate a case of including the recipe, a case of including the control program, or a case of including both the recipe and the control program. The RAM 121b is constituted as a memory area (work area) in which programs or data read by the CPU 121a are temporarily stored.

The I/O port 121d is connected to the MFCs 241a to 241e, 541a, and 541b, the valves 243a to 243e, 543a, and 543b, the humidity sensor 565, the pressure sensor 245, the APC valve 244, the vacuum pump 246, the temperature sensor 263, the heaters 207 and 507, the rotator 267, the boat elevator 115, the shutter opening/closing mechanism 115s, and the like.

The CPU 121a is configured to be capable of reading the control program from the memory 121c and executing the read control program. The CPU 121a is also configured to be capable of reading the recipe from the memory 121c according to input of an operation command from the input/output device 122. The CPU 121a is configured to be capable of controlling various operations such as flow rate regulating operations for various materials (gases) by the MFCs 241a to 241e, 541a, and 541b, opening/closing operations of the valves 243a to 243e, 543a, and 543b, an opening/closing operations of the APC valve 244, a pressure regulating operation by the APC valve 244 based on the pressure sensor 245, an actuating and stopping operation of the vacuum pump 246, temperature regulating operations of the heaters 207 and 507 based on the temperature sensor 263, rotation and rotation speed adjusting operations of the boat 217 by the rotator 267, an operation of moving the boat 217 up or down by the boat elevator 115, and an opening/closing operation of the furnace opening shutter 219s by the shutter opening/closing mechanism 115s, and so on, according to contents of the read recipe.

The controller 121 can be constituted by installing, on the computer, the above-described program recorded and stored in the external memory 123. The external memory 123 includes, for example, a magnetic disk such as a HDD, an optical disc such as a CD, and a semiconductor memory such as a USB memory or a SSD. The memory 121c or the external memory 123 is constituted as a computer-readable recording medium. Hereinafter, the memory 121c or the external memory 123 will be generally and simply referred to as a recording medium. The term "recording medium" used herein may indicate a case of including the memory 121c, a case of including the external memory 123, or a case of including the memory 121c and the external memory 123. The program may be provided to the computer by using communication means or unit such as the Internet or a dedicated line, instead of using the external memory 123.

### (2) Processing Process

As a process (method) of manufacturing a semiconductor device by using the above-described processing apparatus 1, an example of a method of processing a substrate (processing method), i.e., a processing sequence that successively performs a process of etching a surface of a wafer 200 as a substrate and a process of growing a film on the wafer 200 after the etching, will be described mainly with reference to FIGS. 1 and 5A to 5I. In the following description, operations of the respective components constituting the processing apparatus 1 are controlled by the controller 121. The processing apparatus 1 is also be referred to as a substrate processing apparatus, an etching processing apparatus, an etching apparatus, a film formation processing apparatus, or a film formation apparatus, depending on the processing contents. The processing method is also be referred to as a substrate processing method, an etching processing method, an etching method, a film formation processing method, or a film formation method, depending on the processing contents.

A processing sequence in the embodiments includes:
(a) step A of transferring the wafer 200 from the pod 9 to the pod 10;
(b) step B of supplying the substance X to the wafer 200 accommodated in the pod 10; and
(c) step C of transferring the wafer 200 on which the substance X is adsorbed to the process chamber 201 from the pod 10 after step B.

In the following example, a case will be described of performing
(f) step F of allowing the pod 10 to stand for a predetermined period between step B and step C.

In the following example, a case will be described of performing
(d) step D of supplying a heated purge gas to the pod 10 in a state in which the wafer 200 is charged into the pod 10 before performing step B.

In the following example, a case will be described of performing
step G of supplying an etchant to the wafer 200 in the process chamber 201 such that the etchant reacts with the substance X to etch the surface of the wafer 200 after performing step C.

In the following example, a case will be described of
step H of supplying a film-forming agent serving as a processing agent to the wafer 200, the surface of which was etched, to form a film thereon after performing step G.

When the term "wafer" is used herein, it may refer to "a wafer itself" or "a stacked body of a wafer and a predetermined layer or film formed on a surface of the wafer". When the phrase "a surface of a wafer" is used herein, it may refer to "a surface of a wafer itself" or "a surface of a predetermined layer formed on a wafer". When the expression "a predetermined layer is formed on a wafer" is used herein, it may mean that "a predetermined layer is formed directly on a surface of a wafer itself" or that "a predetermined layer is formed on a layer formed on a wafer". When the term "substrate" is used herein, it is synonymous with the term "wafer."

The term "agent" or "substance" as used herein includes at least one selected from the group of a gaseous substance and a liquefied substance. The liquefied substance includes a misty substance. That is, each of the substance X, the etchant, the processing agent, and the reducing agent may include a gaseous substance, a liquefied substance such as a misty substance, or both thereof.

### (Temperature Setting of Gas Supply Pipe 532b)

First, the gas supply pipe 532b is heated by the pipe heater 507 such that an internal temperature of the gas supply pipe 532b reaches a desired temperature. In this case, a state of supplying an electrical power to the pipe heater 507 is feedback-controlled based on temperature information detected by a pipe temperature sensor (not shown) such that a desired temperature distribution is achieved inside the gas supply pipe 532b.

### (Step A: Transferring Wafer 200 from Pod 9 to Pod 10)

Next, the pod 9 accommodating the wafer 200 to be processed arrives at the pod opener 14. The wafer 200 in the pod 9 is transferred by the transfer apparatus 41 into the predetermined pod 10 mounted on the mounting stand 21 of the pod opener 14 *(see* FIGS. 5A to 5C). The pod 10, after being temporarily stored on the pod shelf 11, is conveyed by the pod conveyance mechanism 15 from the shelf plate 13 to one of the pod openers 14 and then is transferred to the mounting stand 21.

An oxide may be formed on the surface of the wafer 200. In some cases, the oxide may include at least one selected from the group of a non-stoichiometric silicon oxide film (SiOₓ film where x is a real number less than 2) and a stoichiometric silicon oxide film (SiO₂ film). The oxide may also include at least one selected from the group of a native oxide and a chemical oxide. Hereinafter, the SiOₓ film or the SiO₂ film is generally referred to as a SiO film.

### (Step D: Supplying Purge Gas to Pod 10)

Next, a purge gas heated to a desired temperature is supplied to the wafer 200 accommodated in the pod 10 *(see* FIG. 5D).

Specifically, the valve 543b is opened to allow the purge gas to flow through the gas supply pipe 532b. A flow rate of the purge gas is controlled by the MFC 541b. Then, the purge gas is supplied into the pod 10 via the gas supply path 549 and is exhausted via the purge port 50. In this case, the heated purge gas is supplied to the wafer 200.

Under conditions described below, by supplying the heated purge gas to the wafer 200 accommodated in the pod 10, moisture (water component) contained in the wafer 200 evaporates and is exhausted via the purge port 50. In this way, the wafer 200 in the pod 10 may be dried.

Processing conditions when supplying the purge gas in step D are shown below:
Processing time: 1 to 10 minutes
Supply flow rate of purge gas: 0.01 to 20 slm, specifically 0.01 to 10 slm

For example, in a case where a temperature sensor serving as a temperature detector is installed in the pod 10 and a heater serving as a heating part is installed near the pod 10, the internal temperature of the pod 10 may be included in the processing conditions. Similarly, in a case where a pressure sensor serving as a pressure detector (pressure detection part) configured to detect an internal pressure of the pod 10 and an APC valve serving as a pressure regulator (pressure regulation part) are installed near the purge port 50 installed in the pod 10, the internal pressure of the pod 10 may be included in the processing conditions. The same applies to step B described later.

As used herein, an expression of a numerical range such as "0.01 to 20 slm" means that a lower limit and an upper limit are included in the range. Therefore, for example, "0.01 to 20 slm" means "0.01 slm or more and 20 slm or less." The same applies to other numerical ranges. Further, as used herein, the term processing temperature refers to a temperature of a space where processing is performed (in steps D and B, the internal temperature of the pod 10 and, in steps G and H, the internal temperature of the process chamber 201). The term processing pressure as used herein refers to an internal pressure of a space where processing is performed (in steps D and B, the internal pressure of the pod 10 and, in steps G and H, the internal pressure of the process chamber 201). The term processing time indicates a time during which the processing is continued. When 0 slm is included in the supply flow rate, this means a case in which the substance (gas) is not supplied. The same applies to the following description.

In step D, a drying level of the wafer 200 may be adjusted by controlling the supply flow rate and supply time of the purge gas. In addition, the supply flow rate and supply time of the purge gas may be controlled based on a measurement result of the humidity sensor 565 installed in pod 10.

An inert gas, for example, may be used as the purge gas. As the inert gas, for example, a noble gas such as nitrogen (N₂) gas, argon (Ar) gas, helium (He) gas, neon (Ne) gas, or xenon (Xe) gas may be used. One or more of these gases may be used as the purge gas.

### (Step B: Supplying Substance X to Wafer 200)

Next, a substance X is supplied to the wafer 200 accommodated in the pod 10 mounted on the pod opener 14.

Specifically, the valve 543a is opened to allow the substance X to flow through gas supply pipe 532a. The substance X is processed by the vaporizer 550, and a flow rate thereof is regulated by the MFC 541a. The substance X is supplied into the pod 10 via the gas supply path 549 and exhausted via the purge port 50. In this case, the substance X is supplied to the wafer 200, thereby exposing the wafer 200 to the substance X (supply of and exposure to the substance X). In this case, the valve 543b may be opened to supply a carrier gas or a dilution gas into the pod 10 via gas supply path 549. When supplying this gas, a state of supplying electric power to the heater 507 may be feedback-controlled based on temperature information detected by a temperature sensor (not shown) such that a desired temperature distribution is achieved inside the pod 10.

At least one selected from the group of the substance X and a part of a molecular structure constituting the substance X (hereinafter, these are generally and simply referred to as the substance X) may be adsorbed on the surface of the wafer 200 by supplying the substance X to the wafer 200 under the following conditions.

Processing conditions when supplying the substance X in step B are shown below:
Processing time: 1 to 10 minutes
Supply flow rate of substance X : 0.01 to 20 slm, specifically 0.01 to 10 slm
Supply flow rate of inert gas: 0 to 20 slm

In step B, a total amount of the substance X supplied to the wafer 200 may be regulated by controlling the supply flow rate and supply time of the substance X by using the MFC 541a. Additionally, the supply flow rate and supply time of the substance X may be controlled based on the measurement result of the humidity sensor 565 installed in the pod 10.

The substance X adsorbed on the wafer 200 reacts with an etchant supplied into the process chamber 201 in step G described later to generate predetermined reaction products (etching species), thereby promoting an etching reaction on the surface of the wafer 200. In other words, the substance X adsorbed on the wafer 200 functions as a reaction-promoting substance that promotes the etching reaction performed in step G.

Therefore, by regulating the amount of the substance X supplied to the wafer 200 in step B, it is possible to increase or decrease the amount of the substance X adsorbed on the wafer 200, thereby controlling the amount of etching of the surface of the wafer 200 in step G described later.

For example, by increasing the supply flow rate of the substance X supplied to the wafer 200 in step B, the amount of the substance X adsorbed on the wafer 200 may increase, thereby increasing the amount of etching of the surface of the wafer 200 in step G described later. Further, for example, by decreasing the supply flow rate of the substance X supplied to the wafer 200 in step B, the amount of the substance X adsorbed on the wafer 200 may decrease, thereby reducing the amount of etching of the surface of the wafer 200 in step G described later.

In addition, the amount of the substance X adsorbed on the wafer 200 may be increased or decreased by regulating the internal temperature of the pod 10 in step B, thereby controlling the amount of etching of the surface of the wafer 200 in step G described later.

For example, by increasing the internal temperature of the pod 10 in step B, it is possible to increase a maximum amount of the substance X (corresponding to an amount of saturation vapor in a case where the substance X is water) that may exist per unit volume inside the pod 10. As a result, the amount of the substance X adsorbed on the wafer 200 in step B may be increased, thereby increasing the amount of etching of the surface of the wafer 200 in step G described later. Further, for example, by lowering the internal temperature of the pod 10 in step B, the amount of the substance X adsorbed on the wafer 200 may be decreased, thereby reducing the amount of etching of the surface of the wafer 200 in step G.

Furthermore, by regulating the supply time of the substance X to the wafer 200 in step B, it is also possible to increase or decrease the amount of the substance X adsorbed on the wafer 200, thereby controlling the amount of etching of the surface of the wafer 200 in step G.

For example, by increasing the supply time of the substance X to the wafer 200 in step B, the amount of the substance X adsorbed on the wafer 200 in step B may be increased, thereby increasing the amount of etching of the surface of the wafer 200 in step G described later. Further, by shortening the supply time of the substance X supplied to the wafer 200 in step B, the amount of the substance X adsorbed on the wafer 200 may be reduced, thereby decreasing the amount of etching of the surface of the wafer 200 in step G described later.

Furthermore, most of the amount of the substance X adsorbed on the wafer 200 in step B may be consumed by performing step G described later. This allows the effect of the substance X on the substrate processing in step H, which is performed after step G, to be avoided. In a case where the amount of the substance X adsorbed on the wafer 200 in step B is excessive or in a case where the consumption of the substance X in step G is insufficient, a part of the adsorbed substance X may be removed from the surface of the wafer 200 in the pod 10 by, for example, increasing the internal temperature of the pod 10 before performing step C after step B. Additionally, for example, after performing step G and before initiating step H, the entirety of the remaining substance X may be removed from the surface of the wafer 200 by increasing the internal temperature of the process chamber 201.

The substance X may include, for example, an oxygen- and hydrogen-containing material such as water (H₂O) or hydrogen peroxide (H₂O₂).

As the carrier gas or the dilution gas, the above-described inert gases may be used. One or more of these gases can be used as the inert gas.

### (Temperature Setting inside Process chamber 201)

After step B is completed or during a period until step B is completed, the process chamber 201 is heated by the heater 207 such that the internal temperature of the process chamber 201 reaches a desired processing temperature. In this case, the state of supplying electric power to the heater 207 is feedback-controlled based on temperature information detected by the temperature sensor 263 such that a desired temperature distribution is achieved inside the process chamber 201.

### (Step F)

After step B completes and during a period until step C described below starts, the pod 10 is allowed to stand on the mounting stand 21 for a predetermined time (step F).

### (Step C: Conveyance of Wafer 200 into Process chamber 201)

Next, the wafer 200 on which the substance X is adsorbed is conveyed into the process chamber 201.

Specifically, the lid of the pod 10 mounted on the mounting stand 21 is separated by the opening/closing mechanism 22, thereby exposing the wafer entrance. Next, the wafer 200 in the pod 10 is then taken out by the transfer apparatus 41 and charged into the boat 217 positioned in the standby part 27 *(see* FIGS. 5F to 5H). Once the internal temperature of the process chamber 201 reaches the desired processing temperature, the furnace opening shutter 219s is moved by the shutter opening/closing mechanism 115s, thereby opening the lower end opening of the manifold 209 (shutter open). Subsequently, the boat 217 supporting the wafer 200 is lifted by the boat elevator 115 and loaded into the process chamber 201 (boat load) *(see* FIG. 5I). In this state, the seal cap 219 seals the lower end of the manifold 209, i.e., the loading/unloading port, via the O-ring 220b.

Thereafter, the interior of the process chamber 201 is vacuum-exhausted (decompression-exhausted) by the vacuum pump 246 so as to reach a desired pressure (degree of vacuum). In this case, the internal pressure of the process chamber 201 is measured by the pressure sensor 245, and the APC valve 244 is feedback-controlled based on the measured pressure information. The rotation of the wafer 200 by the rotator 267 is also started. Heating, exhaust, and rotation of the wafer 200 inside the process chamber 201 continue at least until the processing on the wafer 200 is completed.

### (Step G: Etching)

After completion of step C, an etchant is supplied to the wafer 200 on which the substance X is adsorbed in the process chamber 201.

Specifically, the valve 243a is opened to allow the etchant to flow through the gas supply pipe 232a. A flow rate of the etchant is controlled by the MFC 241a. Then, the etchant is supplied into the process chamber 201 via the nozzle 249a and then exhausted via the exhaust port 231a. In this case, the etchant is supplied to the wafer 200 from a lateral side of the wafer 200, thereby exposing the wafer 200 to the etchant (supply of and exposure to the etchant). In this case, by opening the valves 243d and 243e, the inert gas may be supplied into the process chamber 201 via each of the nozzles 249a and 249b.

By supplying the etchant to the wafer 200 under the following processing conditions, it is possible to react the etchant with the substance X previously adsorbed on the wafer 200 and the boat 217 or a part of a molecular structure of the substance X, thereby etching the surface of the wafer 200.

For example, in a case where an oxide on the surface of the wafer 200 includes silicon oxide (SiO₂), the substance X previously adsorbed on the wafer 200 contains water (H₂O), and the etchant supplied into the process chamber 201 contains hydrofluoric acid (HF) serving as the fluorine-containing material, it is possible to carry out a reaction shown in the following equation under conditions described later. In other words, in step G, it is possible to etch and remove the oxide (SiO₂) present on the surface of the wafer 200 by etching species (HF₂⁻ and the like) generated by reaction of the substance X (H₂O) and the etchant (HF).

2HF + H₂O → HF₂⁻+ H₃O⁺

SiO₂ + 2HF₂⁻ + 2H₃O⁺ → SiF₄ + 4H₂O

As described above, according to the present disclosure, the etching of the oxide (SiO₂) on the surface of the wafer 200 may be triggered by a reaction between the etchant (HF) supplied into the process chamber 201 and a minute amount of the substance X (H₂O) previously adsorbed on the wafer 200 or a part (HₓO) of a molecular structure of the substance X.

Once the etching of the oxide is initiated, the minute amount of the substance X (e.g., water (H₂O)) previously adsorbed on the wafer 200 is consumed. However, in a reaction system of step G, the substance X (e.g., moisture (H₂O)) is generated as a result of the etching of the oxide. Therefore, in step G, it is possible to etch the oxide on the surface of the wafer 200 by causing the aforementioned reaction to be generated successively and repeatedly without additionally supplying the substance X into the process chamber 201. In a case where the substance X is additionally supplied into the process chamber 201 in step G, the amount of the substance X in the reaction system becomes excessive, which may hinder progress of the etching reaction.

After etching the surface of the wafer 200, the valve 243a is closed to stop the supply of the etchant into the process chamber 201. Then, the interior of the process chamber 201 is vacuum-exhausted to remove gaseous substances remaining in the process chamber 201 from the interior of the process chamber 201. In this case, by opening the valves 243d and 243e, the inert gas is supplied into the process chamber 201 via the nozzles 249a and 249b. The inert gas supplied from the nozzles 249a and 249b functions as a purge gas, thereby purging the interior of the process chamber 201.

Processing conditions when supplying the etchant in step G are shown below:
Processing temperature: room temperature (25 degrees C) to 170 degrees C, specifically 25 to 150 degrees C
Processing pressure: 10 to 4,000 Pa, specifically 500 to 2,000 Pa
Supply flow rate of etchant: 0.5 to 3 slm, specifically 1 to 2 slm
Supply time of etchant: 1 to 120 minutes, specifically 10 to 100 minutes
Supply flow rate of inert gas (per gas supply pipe): 0 to 10 slm, specifically 1 to 5 slm

In a case where the processing temperature upon supplying the etchant in step G is set to a temperature lower than room temperature (25 degrees C), an etching rate may be increased. However, when performing another process such as film formation is performed before and/or after the etching process, a time (a time to increase and/or decrease the temperature) to change the processing temperature between the etching process and the another process becomes excessively long, which may reduce productivity.

By setting the above-described processing temperature to room temperature (25 degrees C) or higher, it is possible to reduce the time to change the processing temperature between the etching process and the another process while maintaining a high etching rate, thereby suppressing a decrease in productivity.

In a case where the above-described processing temperature is set to a temperature higher than 170 degrees C, the time to change the processing time between the etching process and the another process may be significantly shortened. However, the etching rate may be excessively low, resulting in decreased productivity.

By setting the above-described processing temperature to 170 degrees C or lower, it is possible to suppress a decrease in the etching rate while maintaining a significant reduction in the time to change the processing temperature between the etching process and the another process, thereby suppressing a decrease in productivity. Further, by setting the processing temperature to 150 degrees C or lower, the reduction in the etching rate may be further suppressed while still maintaining a significant reduction in the time to change the processing temperature between the etching process and the another process, thereby further suppressing a decreases in productivity. By setting the processing temperature to 130 degrees C or lower, a decrease in the etching rate may be significantly suppressed while maintaining a significant reduction in the time to change the processing temperature between the etching process and the another process, thereby greatly suppressing a decrease in productivity.

From the above description, the processing temperature may be set to room temperature (25 degrees C) or higher and 170 degrees C or lower, specifically 25 degrees C or higher and 150 degrees C or lower, and more specifically 25 degrees C or higher and 130 degrees C or lower.

As the etchant, the fluorine-containing material may be used as described above. For example, a fluorine (F)- and hydrogen (H)-containing material such as HF may be used. Alternatively, for example, as the etchant, fluorine (F₂), nitrogen trifluoride (NF₃), chlorine trifluoride (ClF₃), or chlorine monofluoride (ClF) may be used. One or more of these materials may be used as the etchant.

### (Step H: Substrate Processing)

Next, a precursor, which is a film-forming agent, serving as a processing agent is supplied to the wafer 200, the surface of which was etched. In this step, a reducing agent is also supplied together with the precursor to the wafer 200.

Specifically, the valves 243b and 243c are opened to allow the precursor and the reducing agent to flow through the gas supply pipes 232b and 232c, respectively. Flow rates of the precursor and the reducing agent are regulated by the MFCs 241b and 241c, respectively. The precursor and the reducing agent are supplied into the process chamber 201 via the nozzle 249b and exhausted via the exhaust port 231a. In this case, the precursor and the reducing agent serving as the processing agents are supplied to the wafer 200 from the lateral side of the wafer 200, thereby exposing the wafer 200 to the precursor and the reducing agent (supply of and exposure to the precursor and the reducing agent). In this case, the valves 243d and 243e may be opened to supply an inert gas into the process chamber 201 via the nozzles 249a and 249b, respectively.

It is possible to form a predetermined film on the surface of the wafer 200 after the etching process by supplying the precursor and the reducing agent to the wafer 200 under processing conditions described later. For example, in a case where the surface of the wafer 200 exposed by performing the etching process is constituted by single-crystal Si, and materials described later are used as the precursor and the reducing agent, an epitaxial Si film may be grown on the surface of the wafer 200 as the film. The reducing agent acts to maintain the surface of the wafer 200 or the interior of the process chamber 201 in a clean state, thereby enabling proper epitaxial growth and allowing formation of the epitaxial Si film of high-purity.

After forming the predetermined film on the surface of the wafer 200, the valves 243b and 243c are closed to stop the supply of the precursor and the reducing agent into the process chamber 201.

Processing conditions when supplying the precursor and the reducing agent in step D are shown below:
Processing temperature: 500 to 650 degrees C, specifically 550 to 600 degrees C
Processing pressure: 4 to 200 Pa, specifically 1 to 120 Pa
Processing time: 10 to 120 minutes, specifically 20 to 60 minutes
Supply flow rate of precursor: 0.1 to 5 slm, specifically 0.2 to 3 slm
Supply flow rate of reducing agent: 1 to 20 slm, specifically 1 to 10 slm
Supply flow rate of inert gas (per gas supply pipe): 0 to 20 slm, specifically 0.1 to 10 slm

As the processing agent (precursor), for example, silicon hydrides such as monosilane (SiH₄), disilane (Si₂H₆), trisilane (Si₃H₈), or tetrasilane (Si₄H₁₀) may be used. One or more of these materials may be selected as the precursor.

As the reducing agent, for example, a hydrogen-containing material or a deuterium (D)-containing material, such as hydrogen (H₂) or deuterium (D₂), may be used. One or more of these materials may be used as the reducing agent.

After completion of step H, the inert gas serving as the purge gas is supplied into the process chamber 201 from the nozzles 249a and 249b and exhausted via the exhaust port 231a. As a result, the interior of the process chamber 201 is purged, and gases or reaction byproducts remaining in the process chamber 201 are removed from the interior of the chamber (after-purge). Subsequently, an atmosphere inside the process chamber 201 is replaced with the inert gas (inert gas replacement), and the internal pressure of the process chamber 201 is returned to atmospheric pressure (atmospheric pressure recovery).

Thereafter, the seal cap 219 is lowered by the boat elevator 115 to open the lower end of the manifold 209. The processed wafer 200, supported by the boat 217, is unloaded from the lower end of the manifold 209 to the exterior of the reaction tube 203, i.e., into the standby part 27. After the boat is unloaded, the furnace opening shutter 219s moves such that the lower end opening of the manifold 209, i.e., the loading/unloading port, is sealed by the furnace opening shutter 219s via the O-ring 220c.

The processed wafer 200, unloaded into the standby part 27 and supported by the boat 217, is transferred by the transfer apparatus 41 into the pod 9 mounted on the mounting stand 21. The pod 9 accommodating the processed wafer 200 is then conveyed by the pod conveyance mechanism 15 to the load port 8 and unloaded in a subsequent process. The pod accommodating the processed wafer 200 may not be the pod 10 in a wet state due to the supply of the substance X in step B but a pod which is not in a wet state due to non-supply of the substance X, such as the pod 9 accommodating the wafer 200 to be processed in step A.

### (3) Effects of Embodiments

According to the embodiments, one or more of the following effects are obtained.
(a) In step B, the substance X is supplied to the wafer 200 accommodated in the pod 10, and in step C, the wafer 200 on which the substance X is adsorbed is transferred from the pod 10 to the process chamber 201. As a result, the substance X reacts with the etchant in step G, and the resulting reaction products (etching species) may promote the etching reaction. In this way, etching of the surface of the wafer 200 may be performed efficiently.

Since the substance X is adsorbed on the wafer 200 in step B, dummy wafers on which the substance X is adsorbed may not be charged into the boat 217 in step G. This may increase the number of wafers 200 that are processed at a time inside the process chamber 201, thereby improving productivity.

In step B, by supplying the substance X to the wafer 200 accommodated in the pod 10, it is possible to improve uniformity between substrates in an adsorption state of the substance X on the wafer 200, i.e., in a wet state of the wafer 200.

(b) By performing step D, before step B, in a state in which the wafer 200 is charged into the pod 10, the wafer 200 may be dried before the substance X is adsorbed on the wafer 200. Thereby, the wet state of the wafer 200 after step B is performed may be constant. As a result, the etching effect on the wafer 200 may be maintained uniformly.

(c) In step B, the substance X is supplied to the wafer 200 accommodated in the pod 10 mounted on the pod opener 14. That is, the substance X may not be supplied to the wafer 200 inside the transfer chamber 23 or the process chamber 201. Thereby, the substance X remaining in the transfer chamber 23 or non-uniform adsorption of the substance X between substrates or within the substrate surface may be avoided. In addition, poor substrate processing (film formation) caused by the substance X remaining in the nozzle within the process chamber 201 may be avoided.

(d) After performing step B, step F is performed until step C is started to allow the pod 10 to stand for a predetermined time. Thereby, the substance X adsorbed on the wafer 200 in step B may be fixed to the wafer 200. As a result, etching of the surface of the wafer 200 in step G can be performed more efficiently.

(e) Since the total amount of the substance X supplied to the wafer 200 is regulated based on the supply flow rate and supply time of the substance X in step B, the desired amount of the substance X may be adsorbed on the wafer 200. Consequently, the amount of etching of the surface of the wafer 200 in step G may be controlled.

(f) Since the controller 121 controls the first supply system based on the measurement result of the humidity sensor 565 in step B, the desired amount of the substance X can be reliably adsorbed on the wafer 200. As a result, the amount of etching of the surface of the wafer 200 in step G may be reliably controlled. In addition, occurrence of particles may be suppressed.

Additionally, in step B, the humidity of the wafer 200 may be controlled within the pod 10, which is a relatively simple mechanism equipped with the humidity sensor 565 or the purge port 50.

(g) The pod opener 14 is a port configured to be capable of opening or closing the pod 10. In this case, the above effects are effectively obtained.

(h) The aforementioned effects may be similarly obtained even when a predetermined substance is arbitrarily selected and used from the above-described various substances X, various etchants, various processing agents (precursors and reducing agents), and various inert gases.

### (4) Modifications

The processing sequence and the configuration of the processing apparatus 1 in the embodiments may be modified as in the modifications described below. These modifications may be arbitrary combined. Unless otherwise specifically stated, processing procedures and processing conditions in each step of each modification may be the same as those in each step of the above-described processing sequence.

### (First Modification)

In step B, wafers 200 on which the substance X are adsorbed and wafers 200 on which the substance X are not adsorbed may be present. That is, in step B, the substance X may be supplied to some wafers 200 among the plurality of wafers 200 and may not be supplied to the other wafers 200.

For example, the substance X may be supplied to the wafers 200 accommodated in some pods 10 among the plurality of pods 10 and may not be supplied to the wafers 200 accommodated in the other pods 10. Thereby, whether the substance X is adsorbed on the wafers 200 may be determined as described above. In addition, the substance X may be supplied to some wafers 200 among the wafers 200 accommodated in the process chamber 201 and may not be supplied to the other wafers 200. By regulating the number of wafers 200 not supplied with the substance X and the number of wafers 200 supplied with the substance X, the amount of etching species generated in the process chamber 201 or the amount of the substance X generated in the process chamber 201 may be increased or decreased.

In this modification as well, the same effects as the embodiments described above are obtained. In this case, the wafers 200 on which the substance X is adsorbed and the wafers 200 on which the substance X is not adsorbed may be displayed with different colors or icons on the above-described input/output device 122, which is constituted as, for example, a touch panel, etc. so as to identify the wafers 200. This allows the wafers 200 on which the substance X is adsorbed to be arranged at equal intervals when the wafers 200 are charged into the boat 217. It also allows the wafers 200 on which the substance X is adsorbed to be arranged at specific locations within the process chamber 201.

### (Second Modification)

When performing step G, there are cases in which the amount of etching differs depending on the placement positions of the wafers 200 inside the process chamber 201. In these cases, in step B, the amount of the substance X adsorbed on the wafers 200 that are disposed at positions where the amount of etching is small may be greater than the amount of the substance X adsorbed on the other wafers 200. That is, in step B, the amount of the substance X supplied to some wafers 200 among the plurality of wafers 200 may be different from the amount of the substance X supplied to the other wafers 200.

For example, the amount of the substance X supplied to the wafers 200 in each pod 10 among the plurality of pods 10 may differ. Thereby, it becomes possible to vary the amount of the substance X adsorbed on the wafers 200 as described above.

In this modification as well, the same effects as the embodiments described above are obtained. Furthermore, in this modification, in step B, it is also possible to vary the amount of the substance X adsorbed on the wafer 200 depending on the position of the wafer 200 inside the process chamber 201 and thus, in Step G, it becomes possible to regulate the amount of etching of the surface of the wafer 200 depending on the position inside the process chamber 201. As a result, for example, it becomes possible to suppress the variation in the amount of etching of the surface of the wafer 200 depending on the position inside the process chamber 201, i.e., the variation between substrates.

### (Third Modification)

Step D may be performed before starting step B, in a state in which the wafer 200 is not charged into the pod 10. Specifically, for example, step B may be performed after performing step A, and step D may be performed before starting the next step A of transferring the wafer 200 that is not processed from the pod 9 into the pod 10 which is in a wet state.

In this modification as well, the same effects as the embodiments described above are obtained. Furthermore, in this modification, since the humidity inside the pod 10 may be returned to an initial state before starting the next step A, the wet state of the wafer 200 in step B may be made uniform. As a result, it becomes possible to improve the uniformity of the etching process, i.e., uniformity between substrates.

### (Fourth Modification)

Step D may be performed after performing step B, in a state in which the wafer 200 is not charged into the pod 10. Specifically, for example, step C may be performed after performing step B, and then step D may be performed on the pod 10 which is in a wet state and the wafer 200 is not charged thereinto.

In this modification as well, the same effects as the embodiments described above are obtained. Furthermore, in this modification, since humidity inside the pod 10 may be returned to an initial state after performing step C and before starting step B performed subsequently, the wet state of the wafer 200 in the next step B may be uniformly maintained. As a result, it becomes possible to improve the uniformity of the etching process, i.e., uniformity between substrates.

### (Fifth Modification)

Step E of supplying the substance X into the pod 10 may be performed before starting step A.

In this modification as well, the same effects as the embodiments described above are obtained. Furthermore, in this modification, by supplying the substance X into the pod 10 before charging the wafer 200 thereinto, humidity inside the pod 10 may be regulated before the substance X is adsorbed on the wafer 200. Thereby, the amount of adsorption of the substance X on the wafer 200 may be more finely regulated. As a result, etching of the surface of the wafer 200 may be performed more efficiently.

### (Sixth Modification)

The pod shelf 11 as well as the pod opener 14 may be used as the second mounter.

In this modification as well, the same effects as the embodiments described above are obtained. Furthermore, in this modification, since the pod 10 remains in a standby state on the pod shelf 11 after step B is completed and until step C is started, the substance X may be sufficiently fixed to the wafer 200 during this time. As a result, even without providing a step of fixing the substance X to the wafer 200, etching of the surface of the wafer 200 may be performed efficiently. Additionally, the substance X may be supplied to the wafer 200 on the pod shelf 11 instead of supplying the substance X to the wafer 200 on the pod opener 14. Thereby, occupation of the pod opener 14 during the supply step of the substance X may be suppressed. As a result, it is possible to secure the transfer time of the wafer 200 between the pod 9 and the pod 10 on the pod opener 14 or the transfer time of the wafer 200 between the pod 10 and the boat 217. This enables an improvement in the throughput of the substrate processing.

### (Seventh Modification)

The substance X may be supplied to the wafer 200 accommodated in the pod 9 mounted on the load port 8.

In this modification as well, the same effects as the embodiments described above are obtained. Furthermore, since the substance X is supplied to the wafer 200 before step B is started, the amount of adsorption of the substance X on the wafer 200 may be regulated more finely. As a result, etching of the surface of the wafer 200 may be performed more efficiently. In addition, the pod 9 is transported to another processing apparatus within a semiconductor device manufacturing facility. The substance X is likely to affect processing of another processing apparatus. Therefore, in a case where the substance X is supplied to the pod 9, a process of drying the pod 9 may be performed.

### (Eighth Modification)

The humidity sensor 565 is not limited to being installed inside the pod 10 and may also be installed in the first supply system. In this modification as well, the same effects as the embodiments described above are obtained.

### (Ninth Modification)

A moisture absorption state of the wafer 200 may be managed under conditions (flow rate, time, etc.) in which gas containing the substance X is supplied to the pod 10, without installing the humidity sensor 565 in the pod 10 or the first supply system.

### <Other Embodiments of Present Disclosure>

The embodiments of the present disclosure are specifically described hereinabove. However, the present disclosure is not limited to the above-described embodiments, and various changes may be made without departing from the gist thereof.

For example, in the above-described embodiments, a case is descried in which, in step A, the processed wafer 200 is accommodated in a pod, which is the same as the pod 9 that accommodates the wafer 200 to be processed, is not supplied with the substance X, and is not in a wet state. However, the present disclosure is not limited to this embodiment. For example, step C may be performed after step B is performed, and step D may be additionally performed on the pod 10, which is in a wet state and is not charged with the wafer 200, such that the processed wafer 200 may be accommodated in the pod 10, the interior of which is in a dry state. In this case as well, the same effects as the embodiments described above are obtained.

Further, for example, the substance X supplied to the wafer 200 in step B may be a misty substance. In this case as well, the same effects as the embodiments described above are obtained.

Further, for example, in step H, a material containing a semiconductor element other than Si may be used to form a film containing the semiconductor element on the wafer 200. For example, a material containing germanium (Ge), such as monogermane (GeH₄), may be used as a precursor to form a Ge-containing film on the wafer 200. Additionally, a Si-containing material and a Ge-containing material may be used as the precursor to form a Si- and Ge-containing film on the wafer 200. Furthermore, a material containing a metal element such as tungsten (W), molybdenum (Mo), aluminum (Al), titanium (Ti), zirconium (Zr), hafnium (Hf), tantalum (Ta), ruthenium (Ru), vanadium (V), or niobium (Nb) may be used as the precursor to form a metal element-containing film on the wafer 200. In this case as well, the same effects as the embodiments described above are obtained.

Further, for example, in step H, in addition to the epitaxial film, an amorphous film, a polycrystalline film, or a mixed film thereof may be formed on the wafer 200. In this case as well, the same effects as the embodiments described above are obtained.

Furthermore, for example, in step H, instead of forming a film on the wafer 200, the surface of the wafer 200 may be modified into a predetermined surface, or the surface of the wafer 200 may be etched. In this case as well, the same effects as the embodiments described above are obtained.

Recipes used in each process may be provided individually according to the processing contents and may be recorded and stored in the memory 121c via a telecommunication line or the external memory 123. Moreover, at the beginning of each process, the CPU 121a may properly select an appropriate recipe from the recipes recorded and stored in the memory 121c according to the processing contents. Thus, it is possible to form films of various kinds, composition ratios, qualities, and thicknesses with enhanced reproducibility in the processing apparatus 1. Further, it is possible to reduce an operator's burden and to quickly start each process while avoiding an operation error.

The recipes mentioned above are not limited to newly-provided ones but may be provided, for example, by modifying existing recipes that are already installed in the processing apparatus 1. Once the recipes are modified, the modified recipes may be installed in the processing apparatus 1 via a telecommunication line or a recording medium storing the recipes. In addition, the existing recipes already installed in the existing processing apparatus may be directly modified by operating the input/output device 122 of the processing apparatus.

An example in which a process is performed by using a batch-type processing apparatus capable of processing a plurality of substrates at a time is described in the above-described embodiments. The present disclosure is not limited to the above-described embodiments, but may be applied, for example, to a case where a process is performed by using a single-wafer type processing apparatus capable of processing a single substrate or several substrates at a time. In addition, an example in which a process is performed by using a processing apparatus provided with a hot-wall-type process furnace is described in the above-described embodiments. The present disclosure is not limited to the above-described embodiments, but may be applied to a case where a process is performed by using a processing apparatus provided with a cold-wall-type process furnace.

Even in the case of using these processing apparatuses, each process may be performed according to the same processing procedures and processing conditions as those in the above-described embodiments and modifications, and the same effects as the above-described embodiments and modifications may be obtained.

The above-described embodiments or modifications may be used in combination as appropriate. The processing procedures and processing conditions in this case can be, for example, the same as those of the above-described embodiments or modifications.

According to the present disclosure in some embodiments, it is possible to efficiently perform etching of a surface of a substrate.

While certain embodiments are described above, these embodiments are presented by way of example, and are not intended to limit the scope of the disclosure. Indeed, the embodiments described herein may be embodied in a variety of other forms. Furthermore, various omissions, substitutions and changes in the form of the embodiments described herein may be made without departing from the spirit of the disclosure. The accompanying claims and their equivalents are intended to cover such forms or modifications as would fall within the scope and spirit of the disclosure.

## Claims

1. A substrate processing apparatus, comprising:
a first mounter on which a first container configured to be capable of accommodating a substrate is mounted;
a second mounter on which a second container configured to be capable of accommodating the substrate is mounted;
a first supply system configured to supply a substance X to the second container;
a transfer apparatus configured to be capable of transferring the substrate between the first container and the second container;
a process container configured to process the substrate; and
a controller configured to be capable of controlling the first supply system and the transfer apparatus so as to perform:
(a) transferring the substrate from the first container to the second container;
(b) supplying the substance X to the substrate accommodated in the second container; and
(c) after (b), transferring the substrate on which the substance X is adsorbed from the second container to the process container.

2. The substrate processing apparatus of Claim 1, further comprising a second supply system configured to supply a heated purge gas to the second container,
wherein the controller is further configured to be capable of controlling the second supply system so as to perform (d) supplying the purge gas to the second container.

3. The substrate processing apparatus of Claim 2, wherein the controller performs (d) in a state in which the substrate is not charged into the second container.

4. The substrate processing apparatus of Claim 3, wherein the controller performs (d) after (b) or performs (d) before (b).

5. The substrate processing apparatus of Claim 2, wherein the controller performs (d) in a state in which the substrate is charged into the second container, and
wherein (d) is performed before (b).

6. The substrate processing apparatus of Claim 1, wherein the controller is further configured to perform (e) supplying the substance X into the second container, and
wherein (e) is performed before (a).

7. The substrate processing apparatus of Claim 1, wherein the first mounter is a port configured to be capable of opening or closing the first container, and
wherein the second mounter is a port configured to be capable of opening or closing the second container.

8. The substrate processing apparatus of Claim 1, wherein the first mounter is a port configured to be capable of opening or closing the first container, and
wherein the second mounter is a shelf configured to mount the second container.

9. The substrate processing apparatus of any one of Claims 1 to 8, wherein the first supply system supplies the substance X to the substrate accommodated in the second container mounted on the second mounter.

10. The substrate processing apparatus of Claim 9, wherein the second mounter is a port configured to be capable of opening or closing the second container or a shelf configured to mount the second container.

11. The substrate processing apparatus of any one of Claims 1 to 10, further comprising a flow rate controller configured to control a supply flow rate of the substance X in the first supply system,
wherein the flow rate controller is configured to be capable of regulating a total amount of the substance X supplied to the substrate based on the supply flow rate and a supply time of the substance X.

12. The substrate processing apparatus of any one of Claims 1 to 11, further comprising a hygrometer installed in the second container or in the first supply system,
wherein the controller is configured to be capable of controlling the first supply system based on a measurement result of the hygrometer.

13. A method of processing a substrate, comprising:
(a) transferring the substrate from a first container configured to be capable of accommodating the substrate to a second container configured to be capable of accommodating the substrate;
(b) supplying a substance X to the substrate accommodated in the second container; and
(c) after (b), transferring the substrate on which the substance X is adsorbed from the second container to a process container configured to process the substrate.

14. A method of manufacturing a semiconductor device, comprising the method of Claim 13.

15. A program that causes, by a computer, a substrate processing apparatus to perform:
(a) transferring a substrate from a first container configured to be capable of accommodating the substrate to a second container configured to be capable of accommodating the substrate;
(b) supplying a substance X to the substrate accommodated in the second container; and
(c) after (b), transferring the substrate on which the substance X is adsorbed from the second container to a process container configured to process the substrate.
